Europäisches Patentamt

European Patent Office

Office européen des brevets

(11) Veröffentlichungsnummer: **0 021 426**
A1

# EUROPÄISCHE PATENTANMELDUNG

(21) Anmeldenummer: 80103606.2

(22) Anmeldetag: 25.06.80

(51) Int. Cl.³: **H 03 D 9/06,** H 03 F 7/04

(30) Priorität: 27.06.79 DE 2925827

(43) Veröffentlichungstag der Anmeldung: **07.01.81
Patentblatt 81/1**

(84) Benannte Vertragsstaaten: **AT BE CH DE FR GB IT LI LU
NL SE**

(71) Anmelder: **SIEMENS AKTIENGESELLSCHAFT Berlin
und München, Postfach 22 02 61,
D-8000 München 22 (DE)**

(72) Erfinder: **Begemann, Günther, Dipl.-Ing., Forstweg 11,
D-3306 Lehre 1 (DE)**

(54) **Mikrowellen- und Millimeterwellenmischer.**

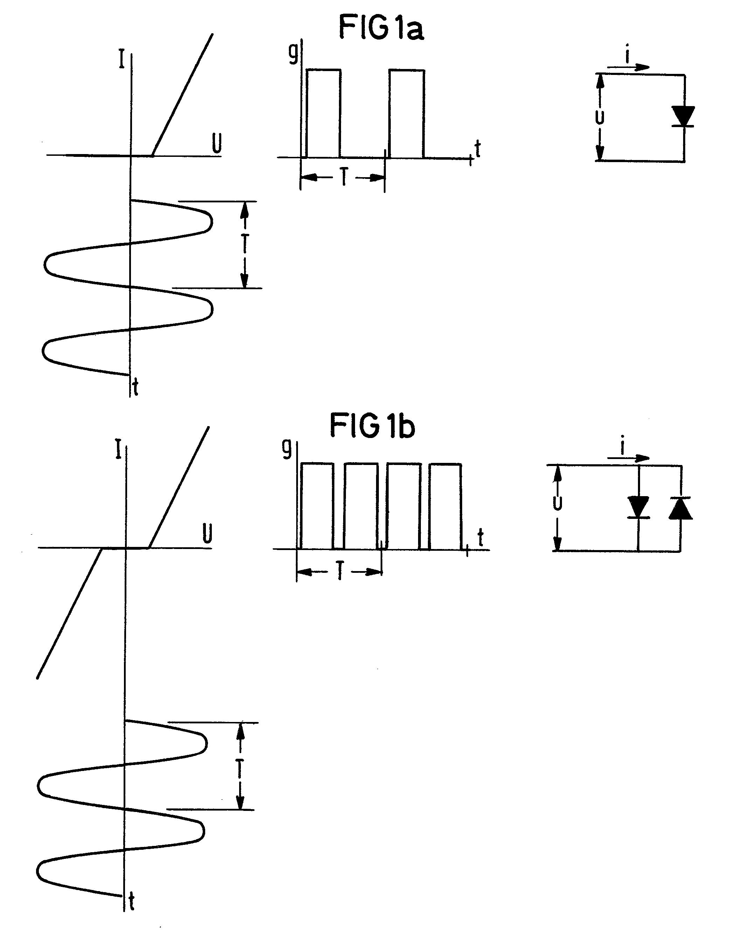

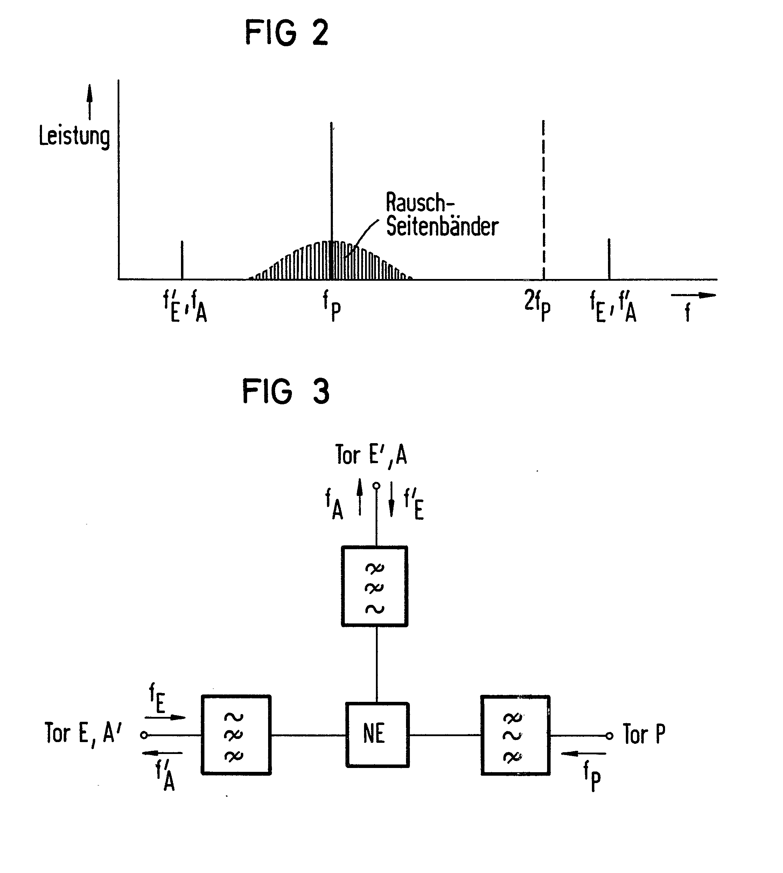

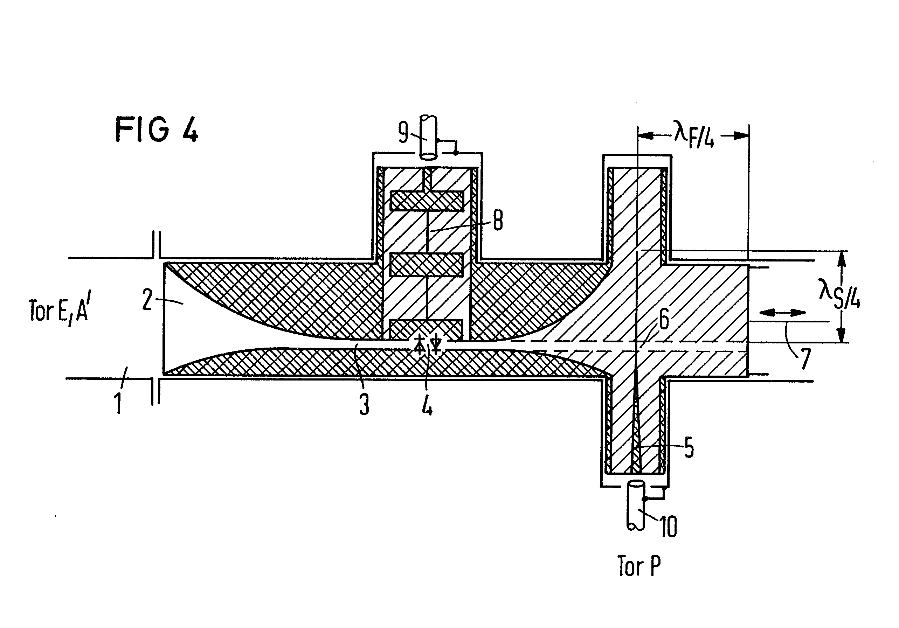

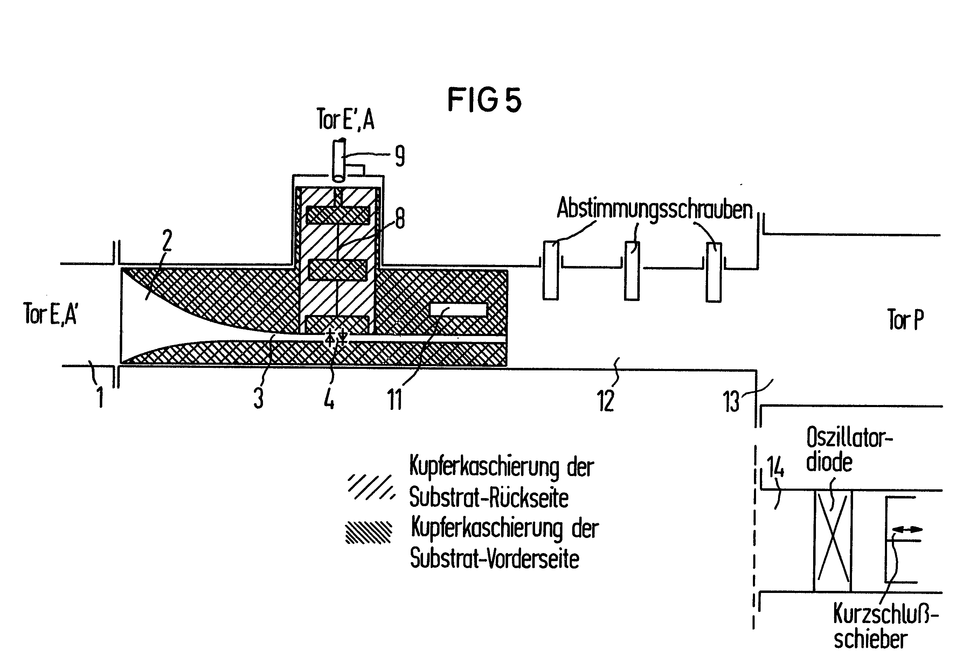

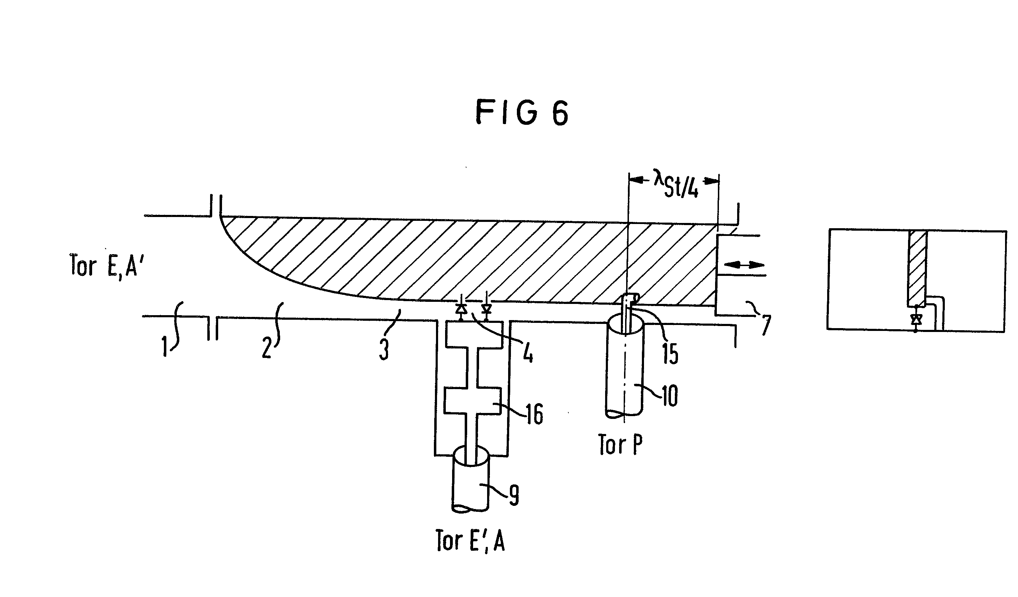

(57) Die Erfindung bezieht sich auf einen Mikrowellen- und Millimeterwellenmischer, bestehend aus zwei antiparallel angeordneten nichtlinearen Elementen. Der Mischer ist mit Wellenleitern aufgebaut, deren Abmessungen in Bezug auf die Frequenz der Pumpenergie ($f_P$), Eingangsenergie ($f_E$) und Ausgangsenergie ($f_A$) so gewählt sind, daß die Pumpenergie ($f_P$) und die Eingangsenergie ($f_E$) auf den Wellenleitern ausbreitungsfähig sind, die Ausgangsenergie ($f_A$) jedoch nicht ausbreitungsfähig ist. Ein solcher Mischer soll einerseits sehr verlustarm sein und andererseits mit sehr einfachen Filtern auskommen. Die Erfindung sieht hierzu vor, daß die Abmessungen des eingangs – (Abwärtsmischer) oder ausgangsseitig (Aufwärtsmischer) angeschlossenen Wellenleiters (1), beispielsweise eines Hohlleiters, so gewählt sind, daß die Frequenzen ($f_E$) oder ($f'_A$), nicht aber die Pumpfrequenz ($f_P$) ausbreitungsfähig sind (Fig. 4).

ACTORUM AG

VPA 79 P 8052 EUR
0021426

## Mikrowellen- und Millimeterwellenmischer

Die Erfindung betrifft einen Mikrowellen- oder Millimeterwellenmischer nach dem Oberbegriff des Anspruchs 1).

Das Prinzip der subharmonischen Mischung, speziell der Abwärtsmischung, ist seit einigen Jahren aus der Literatur bekannt und praktisch erprobt (Büchs, J.-D.: Ein subharmonisch gesteuerter Schottkydiodenmischer in Streifenleitungstechnik, Arch. d. Elektr. u. Übertragungstechn., 25, Nr. 1, 52 - 53, 1976; Büchs, J.-D., Begemann, G.: Frequency Conversion Using Harmonic Mixers with Resistive Diodes. IEE Trans. on Microwaves, Optics, and Acoustics, vol. MoA-2, no. 3, 71 - 76, 1978). Die notwendige Voraussetzung für dieses Mischprinzip ist ein nichtlineares Mischelement mit einer ungeraden Kennlinie. Steuert man ein solches Mischelement mit einer Pumpspannung der Frequenz $f_p$ aus, so hat der für den Mischvorgang entscheidende Zeitverlauf des differentiellen Leitwertes oder Widerstandes eine Grundfrequenz von $2f_p$. Im Vergleich zu herkömmlichen Mischern ist daher nur die Hälfte der Pumpfrequenz zu erzeugen.

Diese Mischer haben die Nachteile, daß sie in Mikrostreifenleitungstechnik ("Mikrostriptechnik") aufgebaut werden müssen und dadurch relativ hohe Verluste aufweisen oder in "Striplinetechnik" aufgebaut werden müssen und dadurch relativ komplizierte Filter benötigen.

Aufgabe der Erfindung ist es, die Nachteile der Mischer des Standes der Technik zu beseitigen und einen Mischer zu schaffen, der einerseits sehr verlustarm ist und andererseits mit sehr einfachen Filtern auskommt.

Erfindungsgemäß wird diese Aufgabe durch die im Kennzeichen des Anspruchs 1) beschriebenen Maßnahmen gelöst. Weitere Ausgestaltungen der Erfindung sind in den Unteransprüchen 2) bis 5) beschrieben.

Diese Mischer sind, insbesondere in der Ausführung als resistive Mischer, anwendbar als breitbandige, verlust- und rauscharme, besonders einfache und billig herstellbare Empfangsmischer, und wegen ihrer spezifischen Eigenschaften besonders geeignet als erste Mischstufe in einem Satellitenfernsehen-Empfänger.

Die Erfindung wird anhand der Zeichnungen näher erläutert.

Es zeigen

Bild 1     den zeitabhängigen differentiellen Leitwert g(t)
           a) einer Schottkydiode
           b) zweier antiparallel geschalteter Schottkydioden,

Bild 2     die spektralen Komponenten des Spannungsverlaufs an zwei anti-
           parallel geschalteten Schottkydioden,

Bild 3     das Blockschaltbild eines subharmonisch gepumpten Mischers,

Bild 4     die Schemazeichnung eines subharmonisch gepumpten Mischers mit
           einer Flossenleitung und einem Mikrostreifenleitungs-Flossenleitungs-
           Obergang,

Bild 5     die Schemazeichnung eines subharmonisch gepumpten Mischers mit
           einer Flossenleitung und einer Pumposzillatoreinkopplung über ein
           Sperrbereichshohlleiter-Filter,

Bild 6     die Schemazeichnung eines subharmonisch gepumpten Mischers mit
           einem Steghohlleiter.

Das Prinzip der subharmonischen Mischung ist in Bild 1 verdeutlicht. Der Einfachheit halber werden ohne Einschränkung der Allgemeingültigkeit Knickkenn-linien angenommen. Das Teilbild 1a zeigt den differentiellen Leitwert g(t) an einer unsymmetrischen Strom-Spannungs-Kennlinie bei Aussteuerung mit einem großen sinusförmigen Signal der Periode T. Die Grundwelle des differentiellen Leitwertes hat die Periode T. Bei Aussteuerung einer ungeraden Kennlinie wie in Teilbild 1b hat die Grundwelle des differentiellen Leitwertes die Periode T/2, d. h. die doppelte Frequenz. Eine Kennlinie wie in Teilbild 1a kann

prinzipiell durch ein nichtlineares Element, eine Kennlinie wie in Teilbild 1b durch eine Antiparallelschaltung zweier nichtlinearer Elemente realisiert werden. Analoge Überlegungen gelten für Ladungs-Spannungs-Kennlinien, wie sie bei Varaktoren auftreten.

Die Vorteile dieses Mischprinzipes sind folgende:

1. Es ist nur die Hälfte der für konventionelle Eintakt- und Gegentaktmischer notwendigen Pumpfrequenz erforderlich. Deshalb können Oszillatoren, welche die Pumpfrequenz direkt erzeugen, einfacher aufgebaut oder in Vervielfacherketten Verdoppler eingespart werden.

2. An einer ungeraden Kennlinie entstehen nur ungerade Vielfache der Pumpfrequenz. Insbesondere die doppelte Pumpfrequenz, die oft nahe der Eingangs- oder Ausgangsfrequenz des Mischers liegt, tritt nicht auf.

3. Pumpfrequenz, Eingangs- und Ausgangsfrequenz liegen in den meisten praktischen Fällen erheblich weiter auseinander als bei konventionellen Mischern, so daß weit geringere Filter- und Diplexerprobleme auftreten. Die Verhältnisse sind in Bild 2 dargestellt. Eine Eingangsleistung der Frequenz $f_E$ oder $f_E'$ wird an den nichtlinearen Mischelementen mit der fiktiven Pumpfrequenz $2f_p$ auf eine Ausgangsleistung bei $f_A$ oder $f_A'$ herunter- oder heraufgemischt. Bei niedrigen Frequenzen $f_A$ oder $f_E'$ beträgt der Abstand zwischen den wesentlich am Mischvorgang beteiligten Frequenzen nahezu $f_p$.

4. Das AM-Rauschspektrum der Pumpquelle, das in Bild 2 mit eingezeichnet ist, wird zwar wie die Eingangsfrequenz an den Mischelementen umgesetzt, seine Mischprodukte

$$n \cdot 2 \cdot f_p \overset{+}{-} f_{rausch}$$

liegen jedoch für n = 1 im gleichen Frequenzbereich wie das ursprüngliche Rauschspektrum, so daß bei genügend großem Abstand zwischen $f_A$ bzw. $f_E'$ und $f_p$ keine nennenswerte Rauschleistung in den Ausgang des Mischers gelangt.

Die Nachteile der subharmonischen Mischung liegen in einer etwas höheren erforderlichen Pumpleistung gegenüber dem Eintaktmischer und in um etwa 0.5 bis 1 dB höheren Konversionsverlusten.

Zur Realisierung des Mischprinzips wird eine Blockschaltung wie in Bild 3 benutzt. Dem Mischertor E,A' wird Hochpaßcharakter mit einer Grenzfrequenz
$f_c(E,A')$ von

$$f_E > f_c(E,A') > f_A, \; f_p$$

und

$$f_A' > f_c(E,A') > f_E', \; f_p$$

gegeben. Das Mischertor E', A erhält einen Tiefpaßcharakter mit einer Grenzfrequenz $f_c(E', A)$ von

$$f_A < f_c(E',A) < f_E, \; f_p$$

und

$$f_E' < f_c(E',A) < f_A', \; f_p \; .$$

Das Tor P erhält Bandpaßcharakter, so daß nur ein Frequenzband um $f_p$ transmittiert, die übrigen Frequenzen aber reflektiert werden.

Mit den Schaltungen, die in Bild 4 bis 6 beschrieben werden, kann die Prinzipschaltung von Bild 3 auf verlustarme, relativ breitbandige, einfache und
billige Weise realisiert werden.

Die Abmessungen des Hohlleiters 1 ohne Steghohlleiter- oder Flossenleitungseinsatz werden so gewählt, daß in diesem Hohlleiter zwar die Frequenzen $f_E$
und $f_A'$, nicht aber die Frequenzen $f_p$, $f_E'$ und $f_A$ ausbreitungsfähig sind.
Die Frequenzen $f_E'$ und $f_A$ sind darüber hinaus auch auf dem Steghohlleiter oder
der Flossenleitung nicht ausbreitungsfähig. Diese Eigenschaft der Schaltung
wird dadurch ermöglicht, daß Steghohlleiter- oder Flossenleitungseinsätze den
Grundwellenbereich eines Hohlleiters erweitern, insbesondere aber die Grenzfrequenz absenken (Saad, A. M. K., Begemann, G.: Electrical Performance of
Finlines of Various Configurations. IEE Trans. on Microwaves, Optics, and
Acoustics, Vol. MOA-1, no. 2, 81 - 88, 1977).

Das Prinzip soll anhand von Bild 4 näher erläutert werden. Es zeigt als ein
mögliches Ausführungsbeispiel die Konstruktion eines resistiven Abwärtsmischers

BAD ORIGINAL

mit einem Flossenleitungseinsatz. Als Signaleingang soll ohne Einschränkung der Allgemeingültigkeit das Tor E,A' gewählt werden. Das Eingangssignal habe die Frequenz

$$f_E = 2 f_p + f_A \cdot$$

Am Tor E,A' werde ein Hohlleiter 1 mit einer Grenzfrequenz

$$f_A, f_p < f_c(E,A') < f_E$$

angeschlossen. Die Eingangsenergie gelangt über einen Hohlleiter-Flossenleitungs-übergang 2 auf eine Flossenleitung 3 mit einer Grenzfrequenz $f_c(F1)$ gemäß

$$f_A < f_c(F1) < f_E + f_p$$

und damit an die nichtlinearen Elemente 4, in diesem Beispiel Schottkydioden. Die Pumpenergie wird in Tor P eingespeist, gelangt auf eine Mikrostreifenleitung 5, die zur besseren Anpassung getapert sein kann, und auf einen Mikrostreifenleitungs-Flossenleitungsübergang 6. Übergänge dieser Art sind in ähnlicher Form, nämlich als Mikrostreifenleitungs-Schlitzleitungsübergänge, aus der Literatur bekannt (Knorr, J. B.: Slot-Line-Transitions. IEEE Trans. on Microwave Theory and Techniques, vol. MTT-22, 548-554, 1974). Zur beidseitigen Feldanpassung muß die Mikrostreifenleitung $\lambda_S/4$ hinter dem Kreuzungspunkt der beiden Leiter in einem Leerlauf, die Schlitzleitung $\lambda_F/4$ hinter dem Kreuzungspunkt in einem Kurzschluß enden. Dabei sind $\lambda_S$ die Wellenlänge auf der Mikrostreifenleitung und $\lambda_F$ die Wellenlänge auf der Schlitzleitung bzw. auf einer Flossenleitung wie in Bild 4. Durch den Leitungscharakter der Anpassungselemente haben diese Übergänge relativ schmale Durchlaßbereiche. In jedem Falle wirken sie, wenn sie für einen Durchlaßbereich um eine Frequenz $f_1$ dimensioniert sind, in einem Band um die doppelte Frequenz $2 f_1$ nahezu als Kurzschluß. Die gleichen Überlegungen gelten wegen der sehr ähnlichen Feldverläufe auf Schlitzleitungen und Flossen-leitungen auch für Mikrostreifenleitungs-Flossenleitungsübergänge. Der für manche Anwendungen nachteilige Filtereffekt dieser Übergänge wird in der vor-liegenden Schaltung zur Trennung von Pump- und Signalfrequenz ausgenutzt. Während die Pumpenergie in einem etwa 30 % breiten Frequenzband weitgehend ungedämpft übertragen wird, wird die Signalenergie in einem relativ etwa ebenso breiten Band reflektiert. Durch Wahl des Abstandes zwischen den Mischelementen und dem Übergang kann der Eingangswiderstand für die Signalfrequenz an Tor E,A' teilweise angepaßt werden. Weitere Freiheitsgrade zur Abstimmung sind der Wellenwiderstand der Flossenleitung und die Pumpleistung. Darüber hinaus kann,
wenigstens im Stadium der Entwicklung, die Länge der Flossenleitung hinter dem
Übergang durch einen variablen Kurzschlußschieber 7 eingestellt und damit der
Übergang optimiert werden.

Das Ausgangssignal der Frequenz $f_A$ gelangt über einen konventionellen Streifenleitungstiefpaß 8 an das Tor E',A. Dort und an Tor P werden Koaxialstecker 9, 10
angeschlossen.

Eine weitere Schaltungsrealisierung in Flossenleitungstechnik ist in Bild 5
dargestellt. Der Mikrostreifenleitungs-Flossenleitungsübergang wird durch eine
Kombination aus Bandstop- und Bandpaßfilter ersetzt. Die Schaltungsteile 1 bis 4,
8 und 9 bleiben unverändert erhalten. Ein Reaktionsresonator 11 dient als Bandsperre für die Frequenzen $f_E$ bzw. $f_A'$ (Knöchel, R.: Design and Performance of
Microwave Oscillators in Integrated Fin-Line Technique. Zur Veröffentlichung eingereicht, IEE Trans. on Microwaves, Optics, and Acoustics), das Sperrbereichshohlleiterfilter 12 (Craven, G. F., Mok, C. K.: The Design of Evanescent Mode
Waveguide Bandpass Filters for a Prescribed Insertion Loss Characteristic.
IEEE on Microwave Theory and Techniques, vol. MTT-19, 295 – 308, 1971) stellt
einen Bandpaß für $f_p$ dar. Der Pumposzillator kann über einen für $f_p$ ausbreitungsfähigen Hohlleiter 13 oder direkt, z. B. als Sperrbereichsoszillator 14,
angeschlossen werden.

Als weiteres mögliches Ausführungsbeispiel gemäß der Erfindung soll ein Mischer
in Steghohlleitertechnik beschrieben werden. Bild 6 zeigt den schematischen Aufbau. Gegenüber der Schaltung von Bild 4 bleiben die Teile 1 bis 4, 7, 9 und
10 prinzipiell erhalten. Teil 2 wird allerdings durch einen Hohlleiter-Steghohlleiterübergang, Teil 3 durch einen Steghohlleiter ersetzt. Der frequenzselektive
Eingang an Tor P wird nun durch einen Koaxialleitungs-Steghohlleiterübergang 15
gebildet. Der Abstand zwischen Übergang und Kurzschluß 7 beträgt ein Viertel der
Steghohlleiterwellenlänge $\lambda_{St}$ bei der Frequenz $f_p$. Als Tiefpaßfilter in Tor E',A
wird eine koaxiale Ausführung 16 verwendet.

Mit den beschriebenen Schaltungen können Abwärts- und Aufwärtsmischer mit resistiven bzw. kapazitiven nichtlinearen Elementen mit den bekannten Vorteilen der
subharmonischen Mischung realisiert werden. Die vorgeschlagenen Schaltungen haben
darüber hinaus folgende spezifische Vorteile:

1. Einfacher und kostengünstiger Aufbau.

2. Geringes Volumen und Gewicht.

3. Relativ große Bandbreite.

Die vorgeschlagenen Mischer eignen sich deshalb ganz besonders, insbesondere in resistiver Ausführung, als einfache und billige Empfängerstufe in Satellitenfernsehen-Empfängern.

Patentansprüche

1) Mikrowellen- und Millimeterwellenmischer, bestehend aus zwei antiparallel angeordneten nichtlinearen Elementen, beispielsweise Festkörperzweipolen, wobei die Pumpfrequenz der nichtlinearen Elemente gleich der Hälfte der Differenz zwischen Eingangs- und Ausgangsfrequenz ist, in ihrer Realisierung mit Wellenleitern, deren Abmessungen in Bezug auf die Frequenz der Pump- energie $(f_p)$, Eingangsenergie $(f_E)$ und Ausgangsenergie $(f_A)$ so gewählt sind, daß die Pumpenergie $(f_p)$ und die Eingangsenergie $(f_E)$ auf den Wellenleitern ausbreitungsfähig sind, die Ausgangsenergie $(f_A)$ jedoch nicht ausbreitungs- fähig ist, wobei die Frequenz der Eingangsenergie $(f_E)$ größer als die Fre- quenz der Pumpenergie $(f_p)$ ist (Abwärtsmischer), oder die Frequenz der Eingangsenergie $(f_E')$ kleiner als die Frequenz der Pumpenergie $(f_p)$ ist (Aufwärtsmischer),

dadurch gekennzeichnet, daß

die Abmessungen des eingangs- (Abwärtsmischer) oder ausgangsseitig (Aufwärtsmischer) angeschlossenen Wellenleiters (1), beispielsweise eines Hohlleiters, so bemessen sind, daß die Frequenzen $(f_E)$ oder $(f_A')$, nicht aber die Pump- frequenz $(f_p)$ ausbreitungsfähig sind.

2) Mischer nach Anspruch 1), dadurch gekennzeichnet, daß der Wellenleiter (3) ein Flossenleiter ist.

3) Mischer nach Anspruch 1), dadurch gekennzeichnet, daß der Wellenleiter (3) ein Steghohlleiter ist.

4) Mischer nach Anspruch 2) und 3), dadurch gekennzeichnet, daß die Frequenz $(f_p)$ über einen frequenzselektiven Übergang (6, Bild 4) auf den

BAD ORIGINAL

Flossenleiter (3, Bild 4) oder einen frequenzselektiven Übergang (11, 12, 13, Bild 5) auf den Flossenleiter (3, Bild 5) oder einen frequenzselektiven Übergang (15, Bild 6) auf den Steghohlleiter (3, Bild 6) eingekoppelt ist, der die Frequenz $(f_p)$ transmittiert, die Frequenzen $(f_E)$ bzw. $(f_A')$ aber reflektiert.

5) Mischer nach Anspruch 1) bis 4), dadurch gekennzeichnet, daß die Frequenzen $(f_E')$ bzw. $(f_A)$ über einen frequenzselektiven Eingang bzw. Ausgang (8, 9, Bild 4, 5) und (16, 9, Bild 6) ein- bzw. ausgekoppelt ist, welcher die Frequenz $(f_p)$ und die Ausgangsfrequenz $(f_A')$ bzw. die Eingangsfrequenz $(f_E)$ reflektiert.

1/5

0021426

FIG 1a

FIG 1b

## FIG 2

Leistung

Rausch-
Seitenbänder

$f'_E, f_A$    $f_P$    $2f_P$    $f_E, f'_A$    $f$

## FIG 3

Tor E′,A

$f_A \uparrow$ ○ $\downarrow f'_E$

$\approx$
$\approx$
$\sim$

$f_E \rightarrow$

Tor E, A′ ○

$f'_A \leftarrow$

$\approx$
$\approx$

NE

$\approx$
$\approx$

○ Tor P

$\leftarrow f_P$

FIG 4

Tor E, A'

$\lambda_F/4$

$\lambda_S/4$

2

1

3

4

6

7

8

9

5

10

Tor P

3/5

0021426

# FIG 5

Tor E',A

Tor E,A'

Abstimmungsschrauben

Tor P

1  2  3  4  11  12  13

9

8

14  Oszillator-diode

Kurzschluß-schieber

///. Kupferkaschierung der Substrat-Rückseite

Kupferkaschierung der Substrat-Vorderseite

# FIG 6

Tor E,A'

$\lambda_{St/4}$

Tor P

Tor E', A

1  2  3  4  16  9  15  10  7

5 / 5

0021426

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | 1979 IEEE MTT-S INTERNATIONAL MICROWAVE SYMPOSIUM DIGEST, 30 April - 2 Mai 1979 New York US FORSYTHE et al.: "Development of a 183GHz Subharmonic Mixer" Seiten 20-21 <br><br> * Seite 20, linke Spalte, Zeilen 1-43; Figur 1 * | 1,4,5 |
| | 1977 IEEE MTT-S INTERNATIONAL MICROWAVE SYMPOSIUM DIGEST, 21-23 Juni 1977 New York US YUAN: "Low Noise Octave Bandwidth Waveguide Mixer", Seiten 480-482 <br><br> * Seite 480, linke Spalte, Zeile 20 - rechte Spalte, Zeile 35; Figur 1 * | 1,3,5 |
| | DE - A - 1 491 905 (G. & E. BRADLEY) <br><br> * Seite 1, Zeile 1 - Seite 7, Zeile 10; Seite 7, Zeile 29 - Seite 9, Zeile 25; Figuren 1, 3 * | 1,3 |
| | 1979 IEEE MTT-S INTERNATIONAL MICROWAVE SYMPOSIUM DIGEST, 30 April - 2 Mai 1979 New York US MEIER: "Printed-Circuit Balanced Mixer for the 4- and 5-mm Bands" Seiten 84-86 <br><br> * Seite 84, rechte Spalte, Zeile 1 - Seite 85, linke Spalte, Zeile 13; Figur 2 * | 1,2,4, 5 |

/

**KLASSIFIKATION DER ANMELDUNG (Int.Cl. 3)**

H 03 D 9/06
H 03 F 7/04

**RECHERCHIERTE SACHGEBIETE (Int. Cl. 3)**

H 03 D 9/06
H 03 D 9/00
H 03 F 7/04
H 03 F 7/00
H 03 D 7/14
H 03 D 7/02
H 03 D 7/04

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 03-10-1980 | DHONDT |

EPA form 1503.1  06.78

BAD ORIGINAL

## EINSCHLÄGIGE DOKUMENTE

| Kategorie | Kennzeichnung des Dokuments mit Angabe, soweit erforderlich, der Maßgeblichen Teile | betrifft Anspruch |
|---|---|---|
| | 1978 IEEE MTT-S INTERNATIONAL MICROWAVE SYMPOSIUM DIGEST, 27-29 Juni 1978 New York US BEGEMANN: "An X-Band Balanced Finline Mixer", Seiten 24-26 <br> * Seite 24, linke Spalte, Zeile 30 - Seite 25, linke Spalte, Zeile 20; Figur 2 * | 1,2,5 |
| | -- | |
| | US - A - 4 032 849 (GYSEL et al.) <br> * Spalte 1, Zeile 64 - Spalte 6, Zeile 3, Figur 1 * | 1,4,5 |
| | -- | |
| | FR - A - 2 389 270 (HOLLANDSE SIG-NAALAPPARATEN) <br> * Seite 1, Zeile 1 - Seite 9, Zeile 6; Figuren 1,2 * <br> & DE - A - 2 816 915 | 1,4,5 |
| | -- | |
| | US - A - 3 890 573 (STRENGLEIN) <br> * Spalte 1, Zeile 54 - Spalte 5, Zeile 7; Figuren 1,11 * | 1,4,5 |
| | -- | |
| | US - A - 4 000 469 (McMASTER) <br> * Spalte 2, Zeile 1 - Spalte 5, Zeile 27; Figuren 1,2 * | 1,4,5 |
| | -- | |
| | CH - A - 510 939 (INTERNATIONAL STANDARD ELECTRIC) <br> * Spalte 1, Zeile 1 - Spalte 3, Zeile 39; Figur 3 * | 1 |
| | ---- | |

KLASSIFIKATION DER ANMELDUNG (Int. Cl.3)

RECHERCHIERTE SACHGEBIETE (Int. Cl.3)

BAD ORIGINAL